# EUROPÄISCHE PATENTSCHRIFT

(11) **EP 4 196 309 B1**
(45) Veröffentlichungstag und Bekanntmachung des Hinweises auf die Patenterteilung: **06.03.2024**
(21) Anmeldenummer: 21754776.9
(22) Anmeldetag: 30.07.2021
(51) Int. Cl.: B23K 20/00, B23K 35/30, B23K 35/32, H01K 1/16, H01K 3/06, B23K 101/36, B23K 103/18

(54) **ANORDNUNG UND VERFAHREN ZUR MECHANISCHEN UND ELEKTRISCHEN KONTAKTIERUNG EINES GLÜHDRAHTES EINER THERMISCHEN STRAHLUNGSQUELLE AUS REFRAKTÄRMETALL FÜR DIE HALBLEITER- UND MIKROSYSTEMTECHNIK**
ARRANGEMENT AND METHOD FOR THE MECHANICAL AND ELECTRICAL CONNECTION OF A FILAMENT OF A THERMAL SOURCE OF RADIATION OUT OF A REFRACTORY METAL FOR THE SEMICONDUCTOR AND MICROSYSTEMS TECHNOLOGY
ARRANGEMENT ET METHODE POUR LA CONNEXION MECHANIQUE ET ELECTRIQUE D'UN FILAMENT D'UNE SOURCE DE RAYONNEMENT THERMIQUE EN METAL REFRACTAIRE POUR LA TECHNOLOGIE DE SEMI-CONDUCTEUR ET MICROSYSTEMES

(30) Priorität: 11.08.2020 DE 102020121157
(43) Veröffentlichungstag der Anmeldung: 21.06.2023
(73) Patentinhaber: Infrasolid GmbH, 01217 Dresden (DE)
(72) Erfinder: SCHOSSIG, Marco, 01189 Dresden (DE)
(74) Vertreter: Querner, Yvonne Anne
(86) Internationale Anmeldenummer: PCT/EP2021/071364
(87) Internationale Veröffentlichungsnummer: WO 2022/033892

(56) Entgegenhaltungen:
- DE-A1- 19 545 296
- DE-A1-102010 040 779
- US-A- 2 145 186
- US-A- 3 561 084
- US-A- 4 370 589

## Beschreibung

Die Erfindung betrifft eine Anordnung zur mechanischen und elektrischen Kontaktierung eines Glühdrahtes einer thermischen Strahlungsquelle gemäß dem Oberbegriff des Anspruchs 1 (siehe z.B. DE 10 2010 040779 A1) wobei die Anordnung einen Glühdraht aus Refraktärmetall mit mindestens einer flachen zu kontaktierenden Anschlussfläche, eine Kontaktfläche auf der der Glühdraht kontaktiert ist, sowie ein Kontaktierungsmittel umfasst, welches den Glühdraht mit der Kontaktfläche verbindet.

Die Erfindung betrifft ebenfalls ein Verfahren zur Herstellung der erfindungsgemäßen Kontaktierung.

Die Strahlungsleistung einer thermischen Strahlungsquelle ist proportional zur vierten Potenz seiner absoluten Temperatur und wird durch das Stefan-Boltzmann-Gesetz beschrieben. Für eine hohe Strahlungsleistung muss der Glühdraht der thermischen Strahlungsquelle folglich eine möglichst hohe Temperatur aufweisen. Dies erfordert ein Material mit einem sehr hohen Schmelzpunkt. Hierfür eignen sich insbesondere Refraktärmetalle, d. h. hochschmelzende, unedle Metalle, wie z. B. Wolfram, Tantal oder Molybdän.

Die bekannteste thermische Strahlungsquelle ist die Glühlampe, bei der ein Glühdraht aus Wolfram durch elektrischen Strom aufgeheizt und zum Leuchten angeregt wird. Die Temperatur des Glühdrahts beträgt je nach Bauform ca. 1500 °C bis 3000 °C. Durch die hohen Temperaturen an den Kontaktstellen und den Stromfluss kann es hierbei zum Materialtransport kommen. Dann kriechen unedle Materialien den Glühdraht entlang und reagieren chemisch mit ihm. Das führt zur Versprödung und es bilden sich Sollbruchstellen, die die Lebenszeit der thermischen Strahlungsquelle verringern. Insbesondere beim Einschalten oder Ausschalten kommt es dann zum Bruch an diesen Versprödungsstellen. Aus diesem Grund ist auf die richtige Materialauswahl der beiden Fügepartner Glühdraht und Kontaktstelle zu achten. Die US 2 145 186 A offenbart z. B. eine Glühlampe in einem versiegelten Kolben, insbesondere eine mechanische Befestigung des Glühfadens an den inneren Zuleitungen.

Refraktärmetalle sind bei Raumtemperatur aufgrund von Passivierung relativ korrosionsbeständig. Bei hohen Temperaturen reagieren sie jedoch sehr leicht mit vielen Nichtmetallen und Gasen, weshalb sehr hohe Anforderungen hinsichtlich Reinheit und Gasdichtheit an das Gehäuse, aber auch die elektrische Kontaktierung, bestehen. Eine sichere und langzeitstabile elektrische Kontaktierung des sehr heißen Glühdrahts wird durch eine Schweißverbindung, meist durch sogenanntes Widerstandspunktschweißen, erreicht. Hierbei verbinden sich Metalle, weil die Atome beider Fügeteile miteinander chemisch oder metallurgisch interagieren und eine feste zusammenhängende Verbindung bilden. Beispielhafte Schweißverbindungen zwischen einem Glühdraht und einem Zuleitungsdraht sind in der US 1 477 618 A, in der DE 10 2004 061 736 A1, in der DE 22 00 736 A sowie in der DE 735 789 A offenbart. Ebenso offenbart die US 4 370 589 A eine Schweißverbindung zwischen einem Glühfaden einer elektrischen Glühlampe und den Zuleitungsdrähten, wobei die inneren Enden der Zuleitungsdrähte gezahnt ausgebildet sind und an den Enden des Glühfadens geschweißt sind, so dass der Glühfaden und die Zuleitungen an mehreren Stellen miteinander verschmolzen sind und diese Stellen starke zuverlässige elektrische Verbindungen bereitstellen.

Durch das Widerstandspunktschweißen können allerdings nicht alle Materialien gleich gut miteinander verbunden werden. Die Ursachen liegen in den physikalischen Eigenschaften und im Zusammenwirken mit den Elektrodenmaterialien. Ideale Materialeigenschaften für das Widerstandspunktschweißen sind:
- gleiche oder nah beieinander liegende Schmelzpunkte
- geringe elektrische Leitfähigkeit
- geringe thermische Leitfähigkeit
- hohe Verformbarkeit (Warmverformbarkeit).

Diese Verhältnisse sind bei realen Schweißaufgaben selten anzutreffen. Harte und spröde Werkstoffe, wie die Refraktärmetalle, tendieren zudem zur Bruchbildung während des Schweiß- und Abkühlungsprozesses. Das beeinflusst die Qualität und Zuverlässigkeit der elektrischen Kontaktierung.

Darüber hinaus ist das Schweißen kein Standardprozess in der Mikroelektronik und Mikrosystemtechnik. Gängige Verfahren sind hier beispielsweise das Drahtbonden und das Flip-Chip-Bonden.

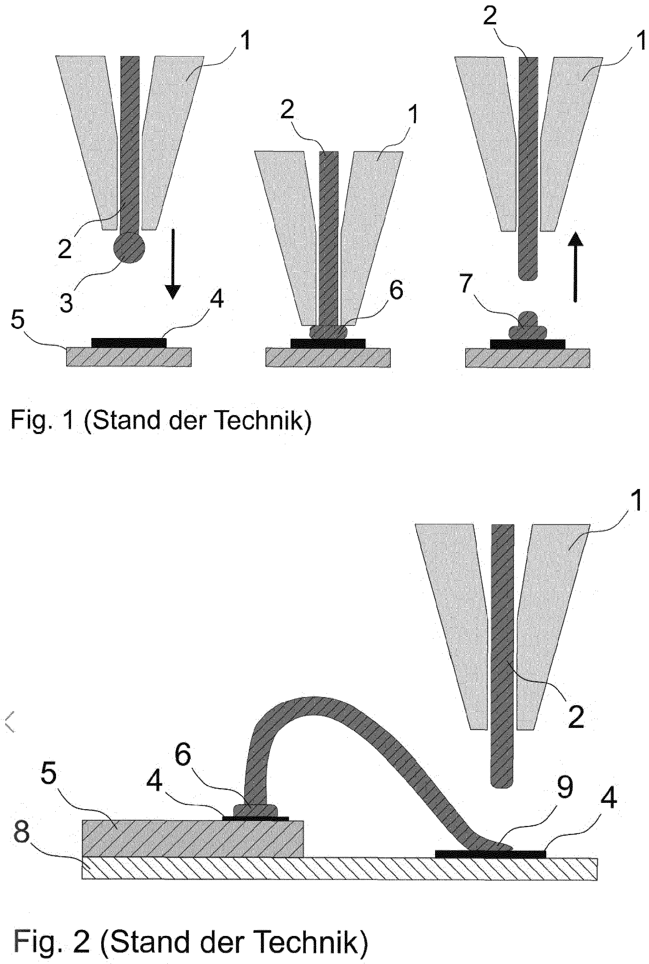

Beim Drahtbonden werden mittels dünner Drähte (Bonddraht) die Anschlüsse eines Bauteils 5 mit den elektrischen Anschlüssen 4 anderer Bauteile oder eines Gehäuses verbunden, siehe Figuren 1 und 2. Als Bondmaterial wird meist Gold, Aluminium oder Kupfer verwendet. Ein sehr häufig angewandtes Drahtbondverfahren ist das sogenannte Ball-Wedge-Bonden. Dabei wird das aus der Kapillare 1 des Drahtbonders unten herausstehende Ende des Bonddrahts 2 angeschmolzen, so dass sich durch die Oberflächenspannung eine Kugel (Ball) 3 bildet. Diese Kugel 3 wird mit Druck, Wärme und Ultraschall auf die Kontaktfläche 4 gebondet und es entsteht ein sogenannter Ballbond 6. Beim Ball-Wedge-Bonden wird dann der Bonddraht 2 zu einer anderen Kontaktfläche 4 gezogen und gebondet, siehe Figur 2. Dies entfällt jedoch beim sogenannten Ball-Bonden, einer speziellen Form des Ball-Wedge-Bonden, das in Figur 1 gezeigt ist. Hierbei wird nach dem ersten Ballbond 6 die Drahtklammer an der Kapillare 1 geschlossen und der Bonddraht 2 wird direkt an der gebondeten Kugel beim Hochfahren der Kapillare 1 durchtrennt. Dadurch entstehen kugelförmige Höcker, sogenannte Bumps, auf der Kontaktfläche 4. Diese werden auch Stud-Bumps 7 genannt. Angewendet wird das Verfahren vor allem in der Flip-Chip-Montage. In der DE 1 949 869 A wird ein Verfahren zum Verbinden eines Glühfadens mit einer metallischen Zuleitung beschrieben, wobei eine Metallperle bis zum plastischen oder einem halbplastischen Zustand erwärmt wird, während die Metallperle gegen die Zuleitung und den darauf liegenden Glühfaden gepresst wird, wobei eine intermetallische oder metallurgische Verbindung durch Diffusion an der Grenzfläche der Metallperle und der Zuleitung entsteht.

Aluminium ist für die Kontaktierung mit einem Glühdraht aus Refraktärmetall ungeeignet, da es ein sehr unedles Metall ist und zudem einen sehr niedrigen Schmelzpunkt besitzt.

Das Edelmetall Gold wird häufig in der Mikroelektronik und Mikrosystemtechnik als Leiterbahn, vor allem auch als Bonddraht, und für Kontaktflächen eingesetzt, da es hervorragende elektrische und thermische Eigenschaften besitzt, sich sehr gut verarbeiten lässt sowie eine hohe Korrosionsbeständigkeit und leichte Lötbarkeit aufweist. Aufgrund der hohen elektrischen und thermischen Leitfähigkeit hat Gold allerdings eine eingeschränkte Schweißeignung. Eine zuverlässige und langzeitstabile Schweißverbindung ist mit einem Refraktärmetall nicht möglich.

In den letzten Jahren beginnt sich das Bonden mit Kupferdraht langsam durchzusetzen, v. a. wegen dem enormen Kostenvorteil. Kupferdraht bietet aber auch noch weitere Vorteile gegenüber Golddraht. Der Gleichstromwiderstand und die thermische Leitfähigkeit sind besser als bei Golddraht. Weiterhin besitzt Kupfer eine höhere mechanische Stabilität und eine bessere Verlässlichkeit des Kontaktes bei erhöhten Temperaturen. Nachteilig ist allerdings die schnelle Oberflächenoxidation von Kupfer, die schon bei Raumtemperatur einsetzt. Ist die Kupferoxidschicht zu dick, kann nicht mehr gebondet werden, da das Material zu hart wird. Außerdem kann dann das Bonddrahtende nicht mehr zu einer Kugel (Ball) angeschmolzen werden, was für die Bildung von Stud-Bumps aber notwendig ist. Wichtig ist daher, dass der Kupferdraht vor Oxidation geschützt wird. Das erfordert eine entsprechende sauerstofffreie Lagerung und Verarbeitung des Kupferbonddrahts. Ähnlich wie bei Gold ist mit Kupfer eine zuverlässige und langzeitstabile Schweißverbindung mit einem Refraktärmetall ebenfalls nicht möglich.

Auch mit den beschriebenen und bekannten Kontaktierungsformen des Drahtbondens für mikroelektronische Bauteile lassen sich harte und spröde Werkstoffe, wie die Refraktärmetalle, nicht zuverlässig und langzeitstabil mit Gold-, Kupfer- oder Aluminiumdraht direkt kontaktieren.

Es ist daher eine Aufgabe der Erfindung, eine zuverlässige und langzeitstabile mechanische und elektrische Kontaktierung von Glühdrähten aus Refraktärmetallen bereitzustellen, die auch mit gängigen Verfahren der Mikroelektronik und Mikrosystemtechnik hergestellt werden kann, damit eine leichte Integration in z. B. mikroelektronische, optoelektronische oder mikrooptoelektromechanische (MOEMS) Systeme möglich ist und ein hoher Automatisierungsgrad erreicht werden kann.

Die Aufgabe wird durch eine Anordnung zur mechanischen und elektrischen Kontaktierung eines Glühdrahtes einer thermischen Strahlungsquelle gemäß dem unabhängigen Anordnungsanspruch gelöst. Erfindungsgemäß weist die flache Anschlussfläche des Glühdrahtes mindestens zwei Perforationen auf und / oder an einem umlaufenden Rand der Anschlussfläche des Glühdrahtes sind mindestens zwei Aussparungen ausgebildet, wobei das Kontaktierungsmittel am Ort der Perforationen und / oder Aussparungen stoffschlüssig mit der Kontaktfläche verbunden ist und durch eine flanschartige Ausbildung des Kontaktierungsmittels oberhalb der Anschlussfläche des Glühdrahtes am Ort der Perforationen und / oder Aussparungen sowohl eine elektrische als auch eine mechanische Verbindung mit dem Glühdraht ausbildet. Unter einer flachen Anschlussfläche ist ein Teil des Glühdrahtes zu verstehen, der auf der Kontaktfläche flächig und eben aufliegt, wobei die Ausdehnung der Anschlussfläche in der Ebene wesentlich größer ist im Vergleich zu ihrer Dicke.

Besonders vorteilhaft ist, dass die Perforationen und / oder Aussparungen in der Anschlussfläche des Glühdrahtes genutzt werden, um den Glühdraht auf einer ebenen Kontaktfläche mit drahtgebondeten Kugeln, sogenannten Stud-Bumps, zu klemmen und damit zu befestigen. Die sich ausbildende Verbindung kontaktiert den Glühdraht aus einem Refraktärmetall sowohl elektrisch als auch mechanisch zuverlässig an der Kontaktfläche. Durch die Kombination der strukturellen Modifikation der flachen Anschlussfläche des Glühdrahtes und des bekannten Ball-Bondens lässt sich mit einem etablierten und hochautomatisierten Verfahren der Halbleiter- und Mikrosystemtechnik ein bisher als nicht langzeitstabil oder nur unter enormen Aufwand kontaktierbares Refraktärmetall zuverlässig und langzeitstabil ohne großen Aufwand kontaktieren.

Die drahtgebondeten Kugeln, die in der Halbleiter- und Mikrosystemtechnik als Stud-Bumps bezeichnet werden und bekannt sind, bilden mit der Kontaktfläche durch Druck, Wärme und Ultraschall eine stoffschlüssige Verbindung, wobei der Bond-Ball im Querschnitt betrachtet eine abgeflachte Kugel darstellt. Diese flanschartige Abflachung wird in der erfindungsgemäßen Anordnung für die mechanische Klemmung der Anschlussfläche des Glühdrahtes auf die Kontaktfläche genutzt, ähnlich einer Nietverbindung. Durch den flächigen Kontakt der Anschlussfläche des Glühdrahtes und der Stud-Bumps in den Perforationen und / oder den Aussparungen am Rand der Anschlussfläche des Glühdrahtes ist auch die elektrische Verbindung gegeben. Im Betrieb der thermischen Strahlungsquelle mit der erfindungsgemäßen Kontaktierung kommt es zusätzlich zu einer thermischen Ausdehnung des Glühdrahtes und des Kontaktierungsmittels, so dass der Kontaktwiderstand zwischen der Anschlussfläche des Glühdrahtes und der Kontaktfläche gegen Null geht.

Der Vorteil gegenüber bisher bekannten Kontaktierungen von Refraktärmetallen liegt insbesondere darin, dass es mit der erfindungsgemäßen Anordnung zu keiner Versprödung der Kontaktstellen des Refraktärmetalls und zu keinem Materialtransport mehr kommt und damit die Lebensdauer eines Bauelements mit Kontaktstellen aus Refraktärmetall wesentlich erhöht werden kann. Diese Kontaktierungsform lässt sich sehr einfach mit etablierten und hochautomatisierten Verfahren der Halbleiter- und Mikrosystemtechnik herstellen und kann somit einfach in den Herstellungsprozess mikroelektronischer, optoelektronischer oder mikroopto-elektromechanischer (MOEMS) Systeme, in denen Refraktärmetalle kontaktiert werden müssen, integriert werden.

In einer Ausgestaltung der erfindungsgemäßen Anordnung sind die Perforationen kreisförmig, dreieckig (n=3), viereckig (n=4) und / oder n-eckig ausgebildet. Dabei ist n eine natürliche Zahl größer 2. Je nach Größe der Stud-Bumps, welche vom Durchmesser des Bonddrahts und den Prozessparametern beim Drahtbonden abhängt, kann damit die mechanische und elektrische Kontaktierung optimiert werden. Typische Bonddrahtdurchmesser liegen im Bereich von (10...50) µm. Daraus ergeben sich Stud-Bumps mit einem Durchmesser von typisch < 100 µm. Der Durchmesser der Perforationen und Aussparungen muss kleiner als der Durchmesser der Stud-Bumps sein, damit eine zuverlässige Klemmung erfolgen kann.

In einer anderen Ausgestaltung der erfindungsgemäßen Anordnung sind die Aussparungen dreieckig (n=3), viereckig (n=4), trapezförmig (n=4), bogenförmig und / oder n-eckig ausgebildet. Dabei ist n eine natürliche Zahl größer 2. Je nach Größe der Stud-Bumps, welche vom Durchmesser des Bonddrahts und den Prozessparametern beim Drahtbonden abhängt, kann damit die mechanische und elektrische Kontaktierung optimiert werden.

Die Anschlussfläche des Glühdrahtes kann sowohl Perforationen als auch Aussparungen oder beides aufweisen, deren Formen frei kombinierbar sind.

In einer weiteren Ausgestaltung der erfindungsgemäßen Kontaktierung sind die Kontaktfläche und das Kontaktierungsmittel vorzugsweise aus Gold und / oder Kupfer. Gold und Kupfer besitzen hervorragende elektrische und thermische Eigenschaften und lassen sich sehr gut verarbeiten. Insbesondere Gold weist zudem eine hohe Korrosionsbeständigkeit und leichte Lötbarkeit auf.

In einer weiteren anderen Ausgestaltung der erfindungsgemäßen Kontaktierung ist das Refraktärmetall des Glühdrahtes Wolfram oder Tantal. Diese Materialien werden bevorzugt in thermischen Strahlungsquellen mit hoher Strahlungsleistung eingesetzt, da sie einen sehr hohen Schmelzpunkt besitzen.

In einer Ausgestaltung der erfindungsgemäßen Kontaktierung ist der Glühdraht über eine Temperatur größer als 700°C aufheizbar ohne das eine chemische Reaktion zwischen dem Glühdraht und der Kontaktierungsstelle auftritt. Die Kontaktierungsstelle bezeichnet den Ort, an dem das Kontaktierungsmittel mit der Kontaktfläche stoffschlüssig verbunden ist und durch die Perforationen und / oder Aussparungen eine mechanische und elektrische Verbindung zwischen der Anschlussfläche des Glühdrahtes und der Kontaktfläche ausbildet. Dies ist nur durch die Kombination aus der modifizierten Anschlussfläche des Glühdrahtes und dem Bonden des Kontaktierungsmittels am Ort der Perforationen und / oder Aussparungen mit der darunterliegenden Kontaktfläche möglich. Da der Glühdraht aus Refraktärmetall keine chemische Verbindung mit der Kontaktfläche eingeht, kann es bei sehr hohen Temperaturen über 700°C zwischen dem Refraktärmetall und dem Material des Kontaktierungsmittels nicht mehr zu einem Stofffluss bzw. zu einem Materialtransport kommen. Das Kriechen unedler Materialien entlang des Glühdrahtes und die chemische Reaktion mit ihm werden damit unterbunden. Eine Versprödung und das Bilden von Sollbruchstellen, die die Lebenszeit der thermischen Strahlungsquelle verringern, treten nicht mehr auf.

Die Aufgabe wird auch durch ein Verfahren zur Herstellung der Anordnung zur mechanischen und elektrischen Kontaktierung eines Glühdrahtes einer thermischen Strahlungsquelle gemäß den Ansprüchen 1 bis 6 gelöst, wobei das Kontaktierungsmittel mittels Drahtbonden am Ort der Perforationen und / oder Aussparungen auf die Kontaktfläche aufgebracht wird und das Kontaktierungsmittel direkt über dem flanschartigen Überstand oberhalb der Anschlussfläche des Glühdrahtes am Ort der Perforationen und / oder Aussparungen abgerissen wird.

Die erfindungsgemäße Anordnung und deren Herstellung sind für den Einsatz in der Halbleiter- und Mikrosystemtechnik vorgesehen und dafür geeignet und ausgebildet.

Im Folgenden soll die Erfindung anhand von Ausführungsbeispielen näher erläutert werden. Die zugehörigen Zeichnungen zeigen
- Fig. 1: Aus der Flip-Chip-Montage bekanntes Ball-Bond-Verfahren zur Herstellung von kugelförmigen Höckern, sogenannten Stud-Bumps, auf einer ebenen Kontaktfläche;
- Fig. 2: Aus dem Stand der Technik bekannte Kontaktierungsform des Drahtbondens bei mikroelektronischen Bauteilen;
- Fig. 3: Ausführungsform der Anschlussfläche eines Glühdrahtes mit Perforationen gemäß der Erfindung: (a) runde Perforation, (b) dreieckige Perforation, (c) rechteckige Perforation, (d) n-eckige Perforation;
- Fig. 4: Ausführungsform der Anschlussfläche eines Glühdrahtes mit Aussparungen gemäß der Erfindung: (a) dreieckige Aussparung, (b) rechteckige Aussparung, (c) trapezförmige Aussparung, (d) Kombination unterschiedlicher Aussparungen;
- Fig. 5: Ausführungsform der Anschlussfläche eines Glühdrahtes aus einem Refraktärmetall mit Perforationen und Aussparungen gemäß der Erfindung: (a) runde Perforationen und trapezförmige Aussparungen, (b) runde Perforationen und dreieckige Aussparungen;
- Fig. 6: Erfindungsgemäße Ausführungsform der Kontaktierung eines Glühdrahtes aus einem Refraktärmetall mit Hilfe von Stud-Bumps;
- Fig. 7: Querschnitt der erfindungsgemäßen Kontaktierung des Glühdrahtes auf der Kontaktfläche an einer Perforation und zwei Aussparungen;

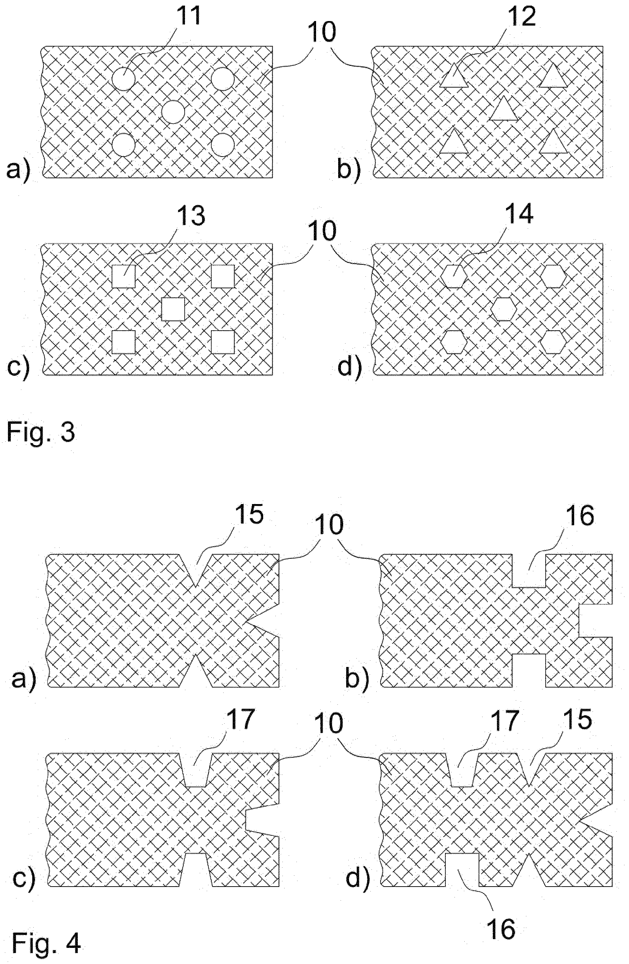

Figur 3 zeigt eine Ausführungsform der erfindungsgemäßen Anschlussfläche 10 eines Glühdrahtes mit unterschiedlichen Formen der Perforationen. Je nach Größe der Stud-Bumps 7, also des Kontaktierungsmittels, welche vom Durchmesser des Bonddrahts und den Prozessparametern beim Drahtbonden abhängt, kann damit die mechanische und elektrische Kontaktierung optimiert werden.

Figur 4 zeigt eine weitere Ausführungsform der erfindungsgemäßen Anschlussfläche 10 eines Glühdrahtes mit unterschiedlichen Formen der Aussparungen. Je nach Größe der Stud-Bumps 7, welche vom Durchmesser des Bonddrahts und den Prozessparametern beim Drahtbonden abhängt, kann damit die mechanische und elektrische Kontaktierung optimiert werden.

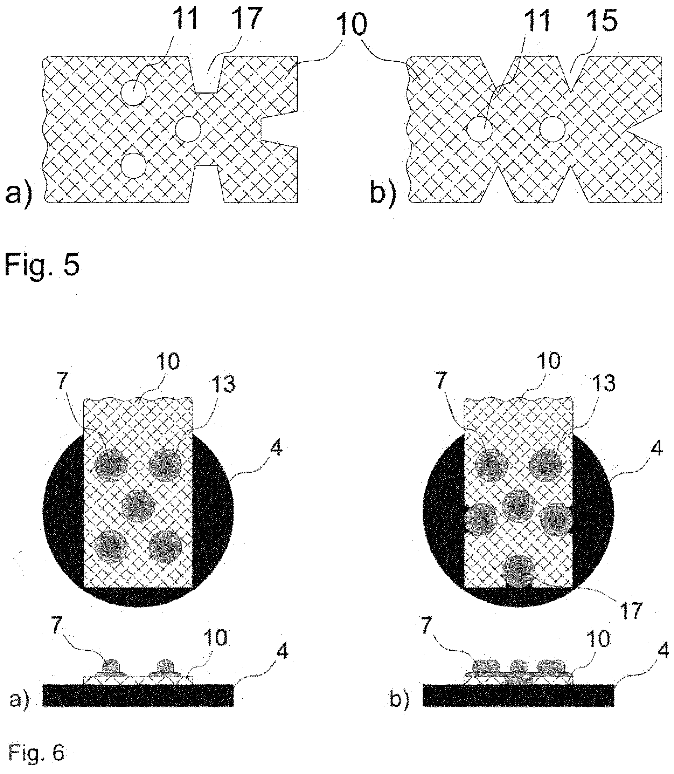

Figur 5 zeigt eine bevorzugte Ausführungsform der erfindungsgemäßen Anschlussfläche 10 eines Glühdrahtes mit unterschiedlichen Formen der Perforationen 11 und der Aussparungen 17. Da der Durchmesser des Bonddrahts nicht beliebig verkleinert werden kann, ist die Kombination von Perforationen 11 und Aussparungen 17 insbesondere bei sehr kleinen Flächen der Kontaktstellen vorteilhaft, weil so eine höhere Anzahl von Kontaktierungsstellen möglich ist. Durch das Setzen eines ersten Stud-Bumps 7 in einer Perforation 11 wird der Glühdraht fixiert und gegen Verrutschen gesichert. Weitere Stud-Bumps 7 in den Aussparungen 17 sorgen dann für die notwendige mechanische Stabilität und einen guten elektrischen Kontakt.

Figur 6 zeigt eine bevorzugte Ausführungsform der erfindungsgemäßen Kontaktierung zwischen der strukturierten Anschlussfläche 10 eines Glühdrahtes aus einem Refraktärmetall und den gebondeten Stud-Bumps 7. Besonders vorteilhaft ist, dass die Perforationen 11 und / oder Aussparungen 17 in der Anschlussfläche 10 des Glühdrahtes genutzt werden, um den Glühdraht auf einer ebenen Kontaktfläche 4 mit den drahtgebondeten Kugeln, den Stud-Bumps 7, zu klemmen und damit zu befestigen. Die sich ausbildende Verbindung kontaktiert den Glühdraht aus einem Refraktärmetall sowohl elektrisch als auch mechanisch zuverlässig an der Kontaktfläche 4. Diese Verbindung ist langzeitstabil, zuverlässig und ohne großen Aufwand herstellbar.

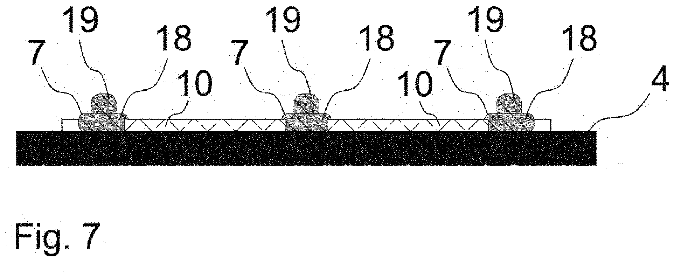

Die Stud-Bumps 7 aus z. B. Gold oder Kupfer bilden mit der Kontaktfläche 4, die ebenfalls z. B. aus Gold oder Kupfer ist, eine stoffschlüssige Verbindung, wobei der gebondete Bond-Ball 3 im Querschnitt betrachtet eine abgeflachte Kugel 18 mit dem abgerissenen Bonddrahtende 19 darstellt (Figur 7). Diese flanschartige Abflachung 18 wird für die mechanische Klemmung der Anschlussfläche 10 des Glühdrahtes auf die Kontaktfläche 4 genutzt, ähnlich einer Nietverbindung. Durch den flächigen Kontakt der Anschlussfläche 10 des Glühdrahtes und der Stud-Bumps 7 in den Perforationen 11 und / oder den Aussparungen 17 am Rand der Anschlussfläche 10 des Glühdrahtes ist auch die elektrische Verbindung gegeben. Im Betrieb der thermischen Strahlungsquelle mit der erfindungsgemäßen Kontaktierung kommt es zusätzlich zu einer thermischen Ausdehnung des Glühdrahtes und des Kontaktierungsmittels (z. B. Golddraht), so dass der Kontaktwiderstand zwischen der Anschlussfläche 10 des Glühdrahtes und der Kontaktfläche 4 gegen Null geht.

Der Vorteil gegenüber bisher bekannten Kontaktierungen von Refraktärmetallen liegt insbesondere darin, dass es mit der erfindungsgemäßen Anordnung zu keiner Versprödung der Kontaktstellen und zu keinem Materialtransport mehr kommt und damit die Lebensdauer eines Bauelements mit Kontaktstellen, die ein Refraktärmetall aufweisen, wesentlich erhöht werden kann. Aufwändige Passivierungen der Kontaktstellen usw. entfallen.

### Bezugszeichenliste

- 1: Kapillare eines Drahtbonders
- 2: Bonddraht
- 3: Ball
- 4: Kontaktfläche, elektrischer Anschluss
- 5: Bauelement
- 6: Ballbond
- 7: Stud-Bump
- 8: Substrat
- 9: Wedge-Bond
- 10: Anschlussfläche/Kontaktfläche eines Glühdrahtes
- 11: Runde Perforation
- 12: Dreieckige Perforation
- 13: Rechteckige Perforation
- 14: n-eckige Perforation
- 15: Dreieckige Aussparung
- 16: Rechteckige Aussparung
- 17: Trapezförmige Aussparung
- 18: Abgeflachte Kugel
- 19: Abgerissener Bonddraht

## Patentansprüche

1. Anordnung zur mechanischen und elektrischen Kontaktierung eines Glühdrahtes einer thermischen Strahlungsquelle, umfassend einen Glühdraht aus Refraktärmetall mit mindestens einer flachen zu kontaktierenden Anschlussfläche (10), eine Kontaktfläche (4) auf der der Glühdraht kontaktiert ist, sowie ein Kontaktierungsmittel (7), welches den Glühdraht mit der Kontaktfläche (4) verbindet, **dadurch gekennzeichnet, dass** die flache Anschlussfläche (10) des Glühdrahtes mindestens zwei Perforationen (11, 12, 13, 14) aufweist und / oder an einem umlaufenden Rand der Anschlussfläche (10) des Glühdrahtes mindestens zwei Aussparungen (15, 16, 17) ausgebildet sind, wobei das Kontaktierungsmittel (7) am Ort der Perforationen (11, 12, 13, 14) und / oder Aussparungen (15, 16, 17) stoffschlüssig mit der Kontaktfläche (4) verbunden ist und durch eine flanschartige Ausbildung (18) des Kontaktierungsmittels (7) oberhalb der Anschlussfläche (10) des Glühdrahtes am Ort der Perforationen (11, 12, 13, 14) und / oder Aussparungen (15, 16) sowohl eine elektrische als auch eine mechanische Verbindung mit dem Glühdraht ausgebildet ist.

2. Anordnung zur mechanischen und elektrischen Kontaktierung eines Glühdrahtes einer thermischen Strahlungsquelle nach Anspruch 1, **dadurch gekennzeichnet, dass** die Perforationen kreisförmig (11), dreieckig (12), viereckig (13) und / oder n-eckig (14) ausgebildet sind.

3. Anordnung zur mechanischen und elektrischen Kontaktierung eines Glühdrahtes einer thermischen Strahlungsquelle nach Anspruch 1, **dadurch gekennzeichnet, dass** die Aussparungen dreieckig (15), viereckig (16), trapezförmig (17), bogenförmig und / oder n-eckig ausgebildet sind.

4. Anordnung zur mechanischen und elektrischen Kontaktierung eines Glühdrahtes einer thermischen Strahlungsquelle nach Anspruch 1, **dadurch gekennzeichnet, dass** die Kontaktfläche (4) und das Kontaktierungsmittel (7) vorzugsweise aus Gold und / oder Kupfer sind.

5. Anordnung zur mechanischen und elektrischen Kontaktierung eines Glühdrahtes einer thermischen Strahlungsquelle nach Anspruch 1, **dadurch gekennzeichnet, dass** das Refraktärmetall des Glühdrahtes Wolfram oder Tantal ist.

6. Anordnung zur mechanischen und elektrischen Kontaktierung eines Glühdrahtes einer thermischen Strahlungsquelle nach Anspruch 1, **dadurch gekenn zeichnet**, dass der Glühdraht über eine Temperatur größer als 700 °C aufheizbar ist, ohne dass eine chemische Reaktion zwischen dem Glühdraht und der Kontaktierungsstelle auftritt.

7. Verfahren zur Herstellung der Anordnung zur mechanischen und elektrischen Kontaktierung eines Glühdrahtes einer thermischen Strahlungsquelle gemäß den Ansprüchen 1 bis 6, wobei das Kontaktierungsmittel (7) mittels Drahtbonden am Ort der Perforationen (11, 12, 13, 14) und / oder Aussparungen (15, 16, 17) auf die Kontaktfläche (4) aufgebracht wird und das Kontaktierungsmittel (7) direkt über dem flanschartigen Überstand oberhalb der Anschlussfläche (10) des Glühdrahtes am Ort der Perforationen und / oder Aussparungen abgerissen wird.

## Claims

1. An arrangement for mechanical and electrical contacting of an incandescent wire of a thermal radiation source, comprising an incandescent wire made of refractory metal having at least one flat connection surface (10) to be contacted, a contact surface (4) on which the incandescent wire is contacted and a contacting medium (7) which joins the incandescent wire to the contact surface (4), **characterized in that** the flat connection surface (10) of the incandescent wire has at least two perforations (11, 12, 13, 14) and/or a circumferential edge of the connection surface (10) of the incandescent wire has at least two cutouts (15, 16, 17), wherein the contacting medium (7) is joined to the contact surface (4) with an atomic-level join at the site of the perforations (11, 12, 13, 14) and/or cutouts (15, 16, 17) and through a flange-like configuration (18) of the contacting medium (7) above the connection surface (10) of the incandescent wire at the site of the perforations (11, 12, 13, 14) and/or cutouts (15, 16) forms both an electrical and a mechanical connection with the incandescent wire.

2. The arrangement for mechanical and electrical contacting of an incandescent wire of a thermal radiation source as claimed in claim 1, **characterized in that** the perforations are circular (11), triangular (12), square (13) and/or n-angular (14).

3. The arrangement for mechanical and electrical contacting of an incandescent wire of a thermal radiation source as claimed in claim 1, **characterized in that** the cutouts are triangular (15), square (16), trapezoidal (17), arcuate and/or n-angular.

4. The arrangement for mechanical and electrical contacting of an incandescent wire of a thermal radiation source as claimed in claim 1, **characterized in that** the contact surface (4) and the contacting medium (7) are preferably made of gold and/or copper.

5. The arrangement for mechanical and electrical contacting of an incandescent wire of a thermal radiation source as claimed in claim 1, **characterized in that** the refractory metal of the incandescent wire is tungsten or tantalum.

6. The arrangement for mechanical and electrical contacting of an incandescent wire of a thermal radiation source as claimed in claim 1, **characterized in that** the incandescent wire is heatable to a temperature above 700°C without a chemical reaction occurring between the incandescent wire and the contacting site.

7. A process for producing the arrangement for mechanical and electrical contacting of an incandescent wire of a thermal radiation source as claimed in claims 1 to 6, wherein the contacting medium (7) is applied to the contact surface (4) at the site of the perforations (11, 12, 13, 14) and/or cutouts (15, 16, 17) by wire bonding and the contacting medium (7) is severed directly above the flange-like projection above the connection surface (10) of the incandescent wire at the site of the perforations and/or cutouts.

## Revendications

1. Agencement pour la mise en contact mécanique et électrique d'un filament d'une source de rayonnement thermique, comprenant un filament en métal réfractaire avec au moins une surface de raccordement plate (10) à mettre en contact, une surface de contact (4) sur laquelle le filament est mis en contact, ainsi qu'un moyen de mise en contact (7) qui relie le filament à la surface de contact (4), **caractérisé en ce que** la surface de raccordement plate (10) du filament présente au moins deux perforations (11, 12, 13, 14) et/ou au moins deux évidements (15, 16, 17) sont réalisés sur un bord périphérique de la surface de raccordement (10) du filament, le moyen de mise en contact (7) étant relié à la surface de contact (4) par liaison de matière à l'emplacement des perforations (11, 12, 13, 14) et/ou des évidements (15, 16, 17), et une liaison aussi bien électrique que mécanique avec le filament étant réalisée par une réalisation (18) en forme de bride du moyen de mise en contact (7) au-dessus de la surface de raccordement (10) du filament à l'emplacement des perforations (11, 12, 13, 14) et/ou des évidements (15, 16) .

2. Agencement pour la mise en contact mécanique et électrique d'un filament d'une source de rayonnement thermique selon la revendication 1, **caractérisé en ce que** les perforations sont réalisées sous forme circulaire (11), triangulaire (12), quadrangulaire (13) et/ou à n angles (14).

3. Agencement pour la mise en contact mécanique et électrique d'un filament d'une source de rayonnement thermique selon la revendication 1, **caractérisé en ce que** les évidements sont réalisés sous forme triangulaire (15), quadrangulaires (16), trapézoïdale (17), en forme d'arc et/ou à n angles.

4. Agencement pour la mise en contact mécanique et électrique d'un filament d'une source de rayonnement thermique selon la revendication 1, **caractérisé en ce que** la surface de contact (4) et le moyen de mise en contact (7) sont de préférence en or et/ou en cuivre.

5. Agencement pour la mise en contact mécanique et électrique d'un filament d'une source de rayonnement thermique selon la revendication 1, **caractérisé en ce que** le métal réfractaire du filament est du tungstène ou du tantale.

6. Agencement pour la mise en contact mécanique et électrique d'un filament d'une source de rayonnement thermique selon la revendication 1, **caractérisé en ce que** le filament peut être chauffé à une température supérieure à 700 °C sans qu'une réaction chimique entre le filament et le point de mise en contact ne se produise.

7. Procédé de fabrication de l'agencement de mise en contact mécanique et électrique d'un filament d'une source de rayonnement thermique selon les revendications 1 à 6,
dans lequel le moyen de mise en contact (7) est appliqué sur la surface de contact (4) au moyen d'une liaison par fil à l'emplacement des perforations (11, 12, 13, 14) et/ou des évidements (15, 16, 17), et le moyen de mise en contact (7) est arraché directement au-dessus de la saillie en forme de bride au-dessus de la surface de raccordement (10) du filament à l'emplacement des perforations et/ou évidements.
